# EUROPÄISCHE PATENTSCHRIFT

(11) **EP 2 521 803 B1**
(45) Veröffentlichungstag und Bekanntmachung des Hinweises auf die Patenterteilung: **20.02.2019**
(21) Anmeldenummer: 10816356.9
(22) Anmeldetag: 20.12.2010
(51) Int. Cl.: C23C 14/54, C23C 16/34, C23C 16/517, H01L 31/0216

(54) **VERFAHREN ZUR ABSCHEIDUNG VON MEHRLAGENSCHICHTEN UND/ODER GRADIENTENSCHICHTEN**
METHOD FOR DEPOSITING MULTI-LAYERED LAYERS AND/OR GRADIENT LAYERS
PROCÉDÉ DE DÉPÔT DE REVÊTEMENTS MULTICOUCHES ET/OU DE COUCHES À GRADIENT

(30) Priorität: 04.01.2010 DE 102010000002
(43) Veröffentlichungstag der Anmeldung: 14.11.2012
(73) Patentinhaber: Meyer Burger (Germany) GmbH, 09337 Hohenstein-Ernstthal (DE)
(72) Erfinder: MAI, Joachim, 04603 Nobitz (DE); SCHLEMM, Hermann, 07743 Jena (DE); GROSSE, Thomas, 08371 Glauchau (DE); DECKER, Daniel, 09427 Ehrenfriedersdorf (DE); GRIMM, Michael, 09116 Chemnitz (DE); SPERLICH, Hans-Peter, 01309 Dresden (DE)
(74) Vertreter: Steiniger, Carmen
(86) Internationale Anmeldenummer: PCT/IB2010/055954
(87) Internationale Veröffentlichungsnummer: WO 2011/080661

(56) Entgegenhaltungen:
- WO-A1-2009/104443
- WO-A2-2007/051457
- DE-A1- 19 814 805
- US-A- 5 589 007
- US-A1- 2004 082 097
- US-A1- 2007 243 386
- US-A1- 2008 092 814
- US-A1- 2009 183 771
- US-B1- 6 268 235

## Beschreibung

Die Erfindung betrifft ein Verfahren zur Abscheidung von Mehrlagenschichten und/oder Gradientenschichten auf wenigstens ein Substrat in einer Inline-Plasmabeschichtungsanlage mit wenigstens einer Prozesskammer, in der wenigstens zwei einzelne Plasmaquellen in Transportrichtung der Substrate nacheinander angeordnet sind, mit plasmaunterstützter chemischer Gasphasenabscheidung (PECVD).

Mehrlagenschichten werden heute zum Beispiel zur Verbesserung der Wärmedämmung, Reflexionssteigerung bzw. Reflexionsminderung oder auch zur Wärmeabsorption auf unterschiedlichen Trägermaterialien eingesetzt. Als Träger werden vorwiegend Platten oder auch Folien aus verschiedenen Materialien verwendet, und diese können dabei unterschiedliche Abmessungen sowie Dicken haben. Anwendungen sind zum Beispiel die Oberflächenvergütung von Architekturgläsern, die Verbesserung der Lichtreflexion von Reflektoren oder Reflektorfolien in der Beleuchtungstechnik oder auch in der Solarthermie zur Steigerung der Lichtabsorption.

Aber auch in der Fotovoltaikindustrie werden zunehmend Mehrlagenschichten bzw. Gradientenschichten verwendet. Diese werden sowohl in Dünnschichtsolarzellkonzepten als auch in waferbasierenden Solarzellkonzepten eingesetzt. Beispiele hierfür sind dünne Schichten zur Antireflexion von Solarzellenoberflächen bzw. unterschiedliche Passivierungsschichten zur Vorderseiten- und Rückseitenpassivierung der Solarzellen. Bei kristallinen Siliziumsolarzellen wird als Antireflexionsschicht häufig eine amorphe wasserstoffhaltige Siliziumnitridschicht verwendet. Für die Rückseitenpassivierung dient meistens ein thermisches Siliziumoxid. Neuerdings werden zur Rückseitenpassivierung auch Stapelschichten aus Siliziumoxid und Siliziumnitrid oder Siliziumoxid und Siliziumkarbid, die mit Hilfe von Plasmabeschichtungsprozesesen hergestellt werden, verwendet. Aber auch verschiedene Aluminiumoxide gewinnen für die Rückseitenpassivierung zunehmend an Bedeutung.

An die verschiedenen Schichten werden teilweise ganz unterschiedliche und manchmal sehr komplexe Anforderungen hinsichtlich deren Funktionseigenschaften gestellt. Zum Beispiel muss eine heute eingesetzte Antireflexionsschicht für kristalline Siliziumsolarzellen neben den optischen Anforderungen gleichzeitig auch Forderungen an die Passivierungseigenschaften erfüllen. Zusätzlich dazu sollen solche Schichten möglichst auch auf komplexeren Oberflächen, wie zum Beispiel der Oberfläche einer Solarzelle mit Textur, geschlossene und haftfeste Schichten ergeben. Gegenüber weiteren Belastungen, wie zum Beispiel einem Feuerungsschritt, müssen die Schichten die notwendige Stabilität aufweisen. Für eine kostengünstige Massenproduktion ist auch noch die Forderung nach hohen Beschichtungsraten zu erfüllen. Hierbei besteht häufig ein Widerspruch, und eine hohe Beschichtungsrate kann nur durch Kompromisse bei den Schichteigenschaften erkauft werden.

Dieser Widerspruch kann zum Beispiel durch einen Schichtstapel aus mehreren Einzelschichten gelöst werden. Dabei können dünne Schichten mit optimierten Schichteigenschaften aber niedriger Beschichtungsrate zum Beispiel mit Schichten verminderter Qualität und dafür aber hohen Beschichtungsraten kombiniert werden.

Die einzelnen Schichten einer Mehrlagenschichtanordnung werden entweder kontinuierlich in einer Inline-Beschichtungsanlage mit mehreren getrennten Prozesskammern oder in einem diskontinuierlichen Batchverfahren nacheinander in einer Prozesskammer aufgebracht. Diese Vorgehensweise ist sehr zeitaufwändig und erfordert einen sehr hohen technischen Aufwand.

Gradientenschichten lassen sich mit solchen Verfahren nur sehr schwierig herstellen. Besonders dann, wenn die einzelnen Schichten eines Schichtstapels zueinander nur eine geringe Änderung in den Schichteigenschaften benötigen, ist eine Trennung der unterschiedlichen Einzelschichtprozesse auf verschiedene Prozesskammern sehr aufwändig.

Beispielsweise beschreibt die Druckschrift WO 2007/051457 ein Verfahren der oben genannten Gattung zur Herstellung von Antireflexionsschichten auf Siliziumsolarzellen, wobei in einem Ausführungsbeispiel in einer Prozesskammer zunächst eine Plasma-CVD-Abscheidung einer SiₓN_{y}:H-Schicht erfolgt und anschließend in einem zweiten Teil der Bereitstellung der chemischen Verbindungen sind vielfach bestimmte Besonderheiten zu beachten. Eine CVD-Anlage zur Herstellung einer bestimmten Schicht wird deshalb oft speziell geplant und ausgeführt. Eine flexible Verwendung einer CVD-Anlage zur Herstellung von Mehrlagenschichten ist im Allgemeinen technisch aufwändig.

Beispielsweise beschreibt die Druckschrift WO 2007/051457 A2 eine Inline-Anlage zur Herstellung einer zweilagigen Antireflexionsbeschichtung auf Silizium-Solarzellen. Dabei wird üblicherweise für die Herstellung jeder Teilschicht eine separate Kammer verwendet. Es ist allerdings auch ein mögliches Ausführungsbeispiel genannt, in dem in einer Kammer eine erste Teilschicht mit einer plasmaunterstützten CVD-Technik abgeschieden und eine zweite Teilschicht in einem weiteren Teil der Vakuumkammer durch ein Sputterverfahren (PVD) hergestellt wird. Eine Kombination einer Sputterabscheidung und einer CVD-Abscheidung in einer Kammer ist aber ungünstig, da unterschiedliche Arbeitsgase für die CVD- und die PVD-Abscheidung benötigt werden und das Arbeitsgas der CVD-Abscheidung vor der PVD-Abscheidung vollständig abgepumpt werden muss, was zeit- und kostenaufwändig ist. PVD-Schichten haben auch einige prinzipielle Nachteile gegenüber CVD-Schichten, beispielsweise kann es bei strukturierten Substraten oder bei Partikeln auf dem Substrat durch Abschattungen zu ungenügenden Beschichtungen kommen.

Die Druckschrift US 2004/0112537 A1 offenbart Inline-Anlagen zur Plasmabearbeitung von Glasscheiben zur Flachbildschirmherstellung. Hierfür werden Plasmaquellen eingesetzt, die bei einer Frequenz zwischen 10 MHz und 500 MHz arbeiten. In einer Ausführungsform sind in einer Prozesskammer mehrere Plasmaquellen nacheinander angeordnet, wobei jede der Plasmaquellen über eine eigene HF-Leistungsquelle verfügt. Mit einer solchen Anlage kann beispielsweise ein Schichtstapel von 50 nm Siliziumoxid und 100 nm Siliziumnitrid kontinuierlich abgeschieden werden. Die unterschiedlichen Schichten werden dabei dadurch erzeugt, dass die einzelnen Plasmaquellen mit unterschiedlichen Gasen versorgt werden.

Aus der Druckschrift US 2008/0102222 A1 sind kontinuierlich arbeitende Plasmaanlagen bekannt, wobei das Plasma ein induktiv gekoppeltes Plasma ist. Die verwendeten Substrate sind typischerweise Folien, die von Rolle zu Rolle während der Auflage auf einer Trommel beschichtet werden. Dabei können in die Trommel mehrere Plasmaquellen angeordnet werden. Die mehreren Plasmaquellen können dafür eingesetzt werden, Mehrlagenschichten abzuscheiden oder eine größere Abscheidegeschwindigkeit zu erzielen.

Aus der Druckschrift DE 198 14 805 A1 sind Beschichtungsverfahren für einen Wischergummi aus Elastomermaterial bekannt, bei denen mehrere, nacheinander angeordnete Plasmaquellen zur CVD-Abscheidung von ineinander übergehenden Schichten eingesetzt werden können. Bei den Plasmaquellen handelt es sich beispielsweise um bei atmosphärischem Druck betriebene Plasmaspritzquellen, die mit unterschiedlichen Gaszusammensetzungen oder Leistungen betrieben werden.

Es ist daher die Aufgabe der vorliegenden Erfindung, ein Verfahren der oben genannten Gattung zur Verfügung zu stellen, mit welchem mehrere unterschiedliche Schichten eines Schichtstapels oder eine sich mit ihrer Dicke hinsichtlich ihrer Eigenschaften ändernde Schicht auf wenigstens einem Substrat in einer einzigen Prozesskammer während des Transportes des Substrates durch die Prozesskammer herstellbar sind.

Die Aufgabe wird durch ein Verfahren zur Abscheidung von Mehrlagenschichten und/oder Gradientenschichten auf wenigstens ein Substrat in einer Inline-Plasmabeschichtungsanlage mit wenigstens einer Prozesskammer, in der wenigstens zwei einzelne Plasmaquellen in Transportrichtung der Substrate nacheinander angeordnet sind, mit plasmaunterstützter chemischer Gasphasenabscheidung, gelöst, wobei die wenigstens zwei Plasmaquellen mit unterschiedlichen Prozessbedingungen bei Anregungsfrequenzen zwischen 10 kHz und 2,45 GHz betrieben werden und für die wenigstens zwei Plasmaquellen linear skalierbare Plasmaquellen mit eigener Gasversorgung und Leistungsversorgung verwendet werden, wenigstens eine der wenigstens zwei Plasmaquellen dabei gepulst wird und das Substrat kontinuierlich oder diskontinuierlich durch die unterschiedlichen Beschichtungsgebiete der einzelnen Plasmaquellen hindurch transportiert wird, wobei die Bewegung der Substrate linear in der Transportrichtung, gegenläufig zu der Transportrichtung oder oszillierend bidirektional ausgeführt wird, und wenigstens ein definierter zweilagiger Schichtstapel mit unterschiedlichen Schichteigenschaften der Einzelschichten und/oder wenigstens eine definierte Gradientenschicht auf dem Substrat abgeschieden wird, wobei die wenigstens zwei Plasmaquellen mit unterschiedlichen elektrischen Betriebsbedingungen betrieben werden und das Betreiben der wenigstens zwei Plasmaquellen mit unterschiedlichen elektrischen Betriebsbedingungen ein Verwenden unterschiedlicher Plasmaanregungsfrequenzen umfasst.

Es wird also eine Prozesskammer verwendet, in der wesentliche Prozessparameter nur einmal eingestellt werden können; beispielsweise kann nur ein Prozessdruck, ein Prozessgasgemisch und ein Temperaturbereich verwendet werden. Die jeweils verwendeten Prozessparameter können in der einen Prozesskammer Gradienten aufweisen. Durch die Gradienten können aber nur geringe Änderungen der substanziell vorgegebenen Parameter bewirken. Erfindungsgemäß werden nun wenigstens zwei Schichten eines Schichtstapels gleichzeitig und/oder eine sich hinsichtlich ihrer Eigenschaften mit der Schichtdicke ändernde Gradientenschicht in ein und derselben Prozesskammer dadurch realisiert, dass die nacheinander in der Prozesskammer vorgesehenen Plasmaquellen mit unterschiedlichen Prozessbedingungen betrieben werden, wobei die unterschiedlichen Prozessbedingungen für diese Plasmaquellen getrennt eingestellt werden können.

Die Prozessbedingungen werden besonders durch alle wichtigen Prozessparameter, wie die Auswahl des Gases oder der Gase, den Gasdruck in der Prozesskammer, den Gasdurchfluss und das Mischungsverhältnis der eingesetzten Gase sowie die elektrischen Betriebsbedingungen der einzelnen Plasmaquellen beeinflusst. Damit kann die Schichtstapel- und/oder Gradientenschichterzeugung sehr effektiv beim Durchtransport des wenigstens einen Substrates durch die Prozesskammer vorgenommen werden, wodurch sich zusätzlich der Effekt ergibt, dass der jeweilige Schichtstapel oder die Gradientenschicht mit definierten Eigenschaften der Einzelschichten bzw. Schichtlagen zur Verfügung gestellt werden kann. Ferner wird mit der erfindungsgemäßen Vorgehensweise vermieden, dass sich Fremdstoffe bzw. Verunreinigungen, die sich bei im Stand der Technik bekannten Verfahren durch den Transport der Substrate in eine andere Prozesskammer ergeben, zwischen bzw. in die abgeschiedenen Schichten oder Schichtlagen einlagern, wodurch hochqualitative Schichtfolgen und/oder Gradientenschichten erzeugt werden können.

Da die Variationsmöglichkeiten der chemischen Prozessparameter begrenzt sind, werden vorzugsweise Variationen an den Plasmaquellen oder an den Betriebsparametern der Plasmaquellen vorgenommen, um Schichtstapel mit unterschiedlichen Schichten oder Gradientenschichten herzustellen. Das heißt, es können erfindungsgemäß funktional und/oder konstruktiv unterschiedliche Plasmaquellen zum Einsatz kommen und/oder gleiche Plasmaquellen unterschiedlich betrieben werden.

In dem erfindungsgemäßen Verfahren zur Abscheidung einer Mehrlagenschicht und/oder Gradientenschicht werden die einzelnen Plasmaquellen mit unterschiedlichen elektrischen Betriebsbedingungen, wie unterschiedlichen Plasmaanregungsfrequenzen, unterschiedlichen effektiven elektrischen Leistungen und/oder unterschiedlichen Pulsparametern, betrieben. Elektrische Parameter besitzen den Vorteil, dass sie zumeist besonders einfach Steuer- und veränderbar sind. Andererseits können elektrische Parameter einen erheblichen Einfluss auf die hergestellten Schichten haben. Beispielsweise hat sich ergeben, dass durch unterschiedliche Plasmaanregungsfrequenzen, unterschiedliche effektive elektrische Leistungen und/oder unterschiedliche Pulsparameter die Eigenschaften von hergestellten Schichten erheblich beeinflusst werden können. Für die Variation der Pulsparameter können beispielsweise unterschiedliche Pulsfrequenzen, Peakleistungen und/oder unterschiedliche Einschalt-dauern der Pulse an die jeweilige Plasmaerzeugungseinrichtung angelegt werden. Somit lassen sich hiermit auf besonders leichte, effektive und vielfältige Weise die Eigenschaften der herzustellenden Schichten einstellen.

In einer günstigen Weiterbildung des erfindungsgemäßen Verfahrens werden wenigstens zwei der Plasmaquellen zu einer oder zu mehreren Gruppen zusammengeschaltet, und die Plasmaquellen in einer Gruppe werden mit gleichen Prozessbedingungen betrieben. Durch das Zusammenschalten von Plasmaquellen wird die Beschichtung von einer Plasmaquelle unter den anderen Plasmaquellen wiederholt durchgeführt. Dadurch wird eine bei dem Substrattransport abgeschiedene Schicht mehrfach abgeschieden, und es wird bei vorgegebener Transportgeschwindigkeit der Substrate eine Skalierbarkeit der Gesamtdicke einer bestimmten Schicht möglich. Es können auch mehrere Gruppen von zusammengeschalteten Plasmaquellen verwendet werden, beispielsweise wenn mehrere Schichten mit jeweils einer hohen Schichtdicke abgeschieden werden müssen. Durch die Zusammenschaltung von mehreren Plasmaquellen zu einer Gruppe kann die gesamte Gruppe mit einer elektrischen Versorgung und mit einer Gasversorgung betrieben werden. Dadurch wird der Ansteueraufwand minimiert.

Bevorzugt werden in dem erfindungsgemäßen Verfahren zur Abscheidung einer Mehrlagenschicht und/oder Gradientenschicht linear skalierbare Plasmaquellen mit eigener Gasversorgung und Leistungsversorgung verwendet. Linear skalierbare Plasmaquellen haben nur in einer Raumrichtung große Ausdehnungen. In einer zweiten Raumrichtung können mehrere Plasmaquellen hintereinander angeordnet werden und mit dem erfindungsgemäßen Verfahren betrieben werden. Die lineare Skalierbarkeit in einer Raumrichtung erlaubt eine einfache Anpassung der Anlagen an Kundenwünsche, wobei die Prozessbedingungen im Wesentlichen übertragen werden können und nicht neu entwickelt werden müssen. Eigene Gasversorgungen und Leistungsversorgungen sind Voraussetzung für den erfindungsgemäßen unterschiedlichen Betrieb der einzelnen Plasmaquellen.

In einer vorteilhaften Variante des erfindungsgemäßen Verfahrens zur Abscheidung einer Mehrlagenschicht und/oder Gradientenschicht wird die wenigstens eine der zwei Plasmaquellen mit einer Plasmaanregungsfrequenz von 10 kHz bis 300 MHz und wenigstens eine weitere der wenigstens zwei Plasmaquellen mit einer Plasmaanregungsfrequenz von 100 MHz bis 2,45 GHz betrieben. Die verwendeten Plasmaanregungsfrequenzen haben einen erheblichen Einfluss auf die Eigenschaften des Plasmas. Bei niedrigen Plasmafrequenzen zwischen 10 kHz und 300 MHz zeichnet sich das Plasma durch einen hohen Anteil an Ionen mit hohen Energien aus, wobei die energiereichen Ionen eine Verdichtung der abgeschiedenen Schichten bewirken. Dadurch werden bei niedrigen Frequenzen hochwertige Schichten hergestellt, welche beispielsweise direkt auf der Substratoberfläche des zu beschichtenden Substrates aufgrund ihrer guten Haftfestigkeit abgeschieden werden können. Allerdings ist die Abscheidegeschwindigkeit dieser Schichten nicht hoch. Ferner kann es auf sensiblen Substratmaterialien dabei auch zu Schädigungen der Substratoberflächen kommen. Bei hohen Frequenzen zwischen 100 MHz und 2,45 GHz erfolgt hingegen eine sehr effektive Anregung und Zersetzung der Prozessgase im Plasma, was zu einer hohen Beschichtungsgeschwindigkeit führt, sodass sich diese Frequenzen zur verhältnismäßig schnellen Erzeugung von Schichten mit hoher Schichtdicke eignen. Die Substratschädigung ist hierbei meistens vernachlässigbar.

In einer Version des erfindungsgemäßen Verfahrens werden die wenigstens zwei Plasmaquellen mit gepulster Versorgungsleistung betrieben, wobei die Versorgungsleistungen zueinander synchronisiert bzw. phasengleich oder phasenversetzt sind. Ein gepulstes Plasma hat andere Charakteristiken als ein kontinuierlich brennendes Plasma, auch die Eigenschaften der hergestellten Schichten unterscheiden sich folglich in Abhängigkeit davon, ob sie mit einem gepulsten Plasma oder mit einem kontinuierlich brennenden Plasma abgeschieden worden sind. Durch ein gepulstes Plasma kann beispielsweise die Energieverteilung der Elektronen im Plasma beeinflusst werden. Auch ist das zeitliche Generieren und Vernichten von Ladungsträgern oder auch von Fragmenten und Anregungszuständen von Teilchen im Plasma von der Pulsung abhängig. So können die unterschiedlichen Plasmaeigenschaften im Pulsbetrieb gezielt dazu verwendet werden, die Schichteigenschaften der herzustellenden Schichtfolge oder Gadientenschicht zu steuern. Auch der Grenzbereich zwischen zwei Plasmaquellen, der einem Grenzbereich zwischen zwei Schichten oder einem Gradientenübergang zwischen zwei Schichten entspricht, kann durch Pulsparameter gezielt beeinflusst werden. Insbesondere kann hierfür die phasengleiche oder phasenversetzte Pulsung von benachbarten Plasmaquellen verwendet werden.

Vorzugsweise werden in dem erfindungsgemäßen Verfahren mehrere Substrate beim Transport durch die unterschiedlichen Beschichtungsgebiete der Plasmaquellen bei gleicher definierter Substrattemperatur von maximal 600ºC beschichtet. Die Substrattemperatur bestimmt wesentlich die chemischen Vorgänge auf der Substratoberfläche, die Adsorption von Radikalen, ihre chemische Reaktion mit der Oberfläche, eventuell die Kristallisation der Schicht, die Ausheilung von Schichtbaufehlern und die Desorption von Reaktionsendprodukten. Häufig werden optimale Schichteigenschaften bei erhöhten Temperaturen erreicht. Temperaturänderungen der Substrate sind andererseits nur mit begrenzten Geschwindigkeiten möglich. Insbesondere für eine gleichmäßige Einstellung der Temperatur auf allen Substraten sind nach Temperaturänderungen Stabilisierungszeiten erforderlich. Zur Gewährleistung einer hohen Temperaturstabilität wird die Substrattemperatur im einfachsten Fall bei der Beschichtung in einer Beschichtungskammer konstant gehalten.

In einer Modifikation des erfindungsgemäßen Verfahrens werden mit zwischen den einzelnen Plasmaquellen angeordneten Leitwertblenden Gasvermischungen verringert. Wenn benachbarte Plasmaquellen mit unterschiedlichen Gasen betrieben werden, kommt es durch Diffusion zu einer Vermischung der Gase der beiden Plasmaquellen. Vom Gaseinlass zur Gasabsaugung stellen sich Konzentrationsgradienten ein. Diese Gradienten können gezielt zur Herstellung von Gradientenschichten genutzt werden. Die fließenden Übergänge der Gaszusammensetzungen können aber auch unerwünscht sein, da scharfe Übergänge zwischen zwei Schichten gewünscht sind. Eine Reduzierung von Gasvermischungen von zwei Plasmaquellen wird in der beschriebenen Variante durch die Leitwertblenden zwischen den Plasmaquellen erreicht.

In einem weiteren Ausführungsbeispiel für das erfindungsgemäße Verfahren ist die Mehrlagenschicht und/oder die Gradientenschicht eine aus wenigstens zwei Siliziumnitridschichten mit unterschiedlicher Schichtzusammensetzung und Schichtdicke aufgebaute Antireflexionsbeschichtung für kristalline Solarzellen, wobei eine erste Siliziumnitridschicht derart abgeschieden wird, dass sie als Oberflächenpassivierungsschicht auf dem Substrat wirkt, und eine zweite Siliziumnitridschicht derart auf der ersten abgeschieden wird, dass sie als Wasserstoffquelle wirkt und gemeinsam mit der ersten Siliziumnitridschicht die Anforderung an eine Lambda/4-Entspiegelung erfüllt. Die optische Schichtdicke einer Antireflexionsbeschichtung wird durch optische Gesetze bestimmt.

Sie muss ein Viertel der Auslegungswellenlänge betragen. In dem genannten Ausführungsbeispiel wird die Antireflexionsschicht aus zwei Teilschichten ausgebildet, die in der Summe als eine optische Schicht wirken. Die zwei Teilschichten erfüllen aber unterschiedliche weitere Anforderungen. Die erste Siliziumnitridschicht wird so abgeschieden, dass sich eine optimale Oberflächenpassivierung des Substrates ergibt und die zweite Siliziumnitridschicht wird so abgeschieden, dass sie viel Wasserstoff enthält, der später als Wasserstoffquelle wirkt, der für die Ausheilung der Substratoberfläche erforderlich ist.

In einer günstigen Variante des erfindungsgemäßen Verfahrens wird eine zweilagige Mehrlagenschicht mit einer ersten Schicht, die mit einer ersten Beschichtungsrate abgeschieden wird, und einer zweiten Schicht, die mit einer vergleichsweise hohen zweiten Beschichtungsrate abgeschieden wird, ausgebildet. Die Anfangsphase einer Beschichtung stellt eine Besonderheit dar, da die Unterlage für die wenigstens die erste Atomlage einer Schicht eine andere ist als eine spätere Lage der Schicht, die bereits das Schichtmaterial als Unterlage vorfindet. Zur Realisierung der gewünschten Schichteigenschaften ist es häufig wichtig, besonderes Augenmerk insbesondere auf die ersten Lagen einer Schicht zu legen. Eine hochwertige erste Schicht erfordert häufig den Einsatz einer geringen Beschichtungsrate für diese erste Schicht. Für die weiteren Lagen einer Schicht bzw. eine zweite Schicht kann hingegen eine hohe Beschichtungsrate verwendet werden, die auf einer hochwertigen Substratunterlage dann auch zu hochwertigen Schichten führt.

In einer gebräuchlichen Version des erfindungsgemäßen Verfahrens wird die erste Schicht mit Hilfe einer HF-Plasmaquelle, die mit einer Plasmaanregungsfrequenz in einem Bereich von 10 KHz bis 13,56 MHz betrieben wird, und eine zweite Schicht mit Hilfe einer Mikrowellenplasmaquelle, die mit einer Plasmaanregungsfrequenz von 915 MHz oder 2,45 GHz betrieben wird, abgeschieden. Bei diesen Frequenzen existieren ausgereifte Plasmaquellen, die bevorzugt zum Einsatz kommen. Es könnten jedoch auch andere als die heute üblichen Frequenzen, zum Beispiel nach einer Änderung der Gesetzeslage, zum Einsatz kommen.

In einer vorteilhaften Modifikation des erfindungsgemäßen Verfahrens wird vor dem Abscheiden einer ersten Schicht der Mehrlagenschicht und/oder der Gradientenschicht eine Plasmavorbehandlung der Substratoberfläche des Substrates in der gleichen Prozesskammer durchgeführt, in der auch die Plasmabeschichtung erfolgt. Für ein optimales Schichtwachstum ist eine optimale Grenzfläche zum Substrat erforderlich. Normale, unvorbehandelte Substratoberflächen können Verschmutzungen und/oder Adsorbate wie zum Beispiel Wasser aufweisen. Die Oberfläche von Substraten kann auch in einem Zustand sein, zum Beispiel bei Kunststoffsubstraten, der für ein gutes Schichtwachstum mit sehr guter Schichthaftung ungünstig ist. Bei empfindlichen Grenzflächen kann es deshalb günstig sein, direkt in der Prozesskammer eine Plasmavorbehandlung durchzuführen, die eine saubere konditionierte Substratoberfläche für die Plasmabeschichtung bereitstellt. Durch die Plasmavorbehandlung direkt vor der Plasmabeschichtung wird eine optimale Wirkung erreicht. Wird bei der Plasmavorbehandlung beispielsweise eine oberflächliche Oxidschicht entfernt, ist die Wiederoxidation der Oberfläche minimal, wenn die Plasmavorbehandlung in-situ erfolgt.

In einer abweichenden Modifikation des erfindungsgemäßen Verfahrens umfasst die Plasmavorbehandlung eine Plasmaoxidation. In manchen Anwendungsbeispielen kann es günstig sein, das Substrat vor Aufbringen der Schicht zu oxidieren. Ein Oxid, das zum Beispiel durch Plasmaoxidation aus der Substratoberfläche gebildet wird, ist eine besonders hochwertige Schicht, die auch eine hervorragende Haftung zum Substrat aufweist. In verschiedenen Anwendungsbeispielen ist eine durch Plasmaoxidation hergestellte Interfaceoxidschicht ein günstiger Bestandteil des Gesamtschichtstapels.

In einer günstigen Weiterbildung des erfindungsgemäßen Verfahrens wird die Mehrlagenschicht und/oder die Gradientenschicht auf der oxidierten Substratoberfläche in der gleichen Prozesskammer abgeschieden, wobei die Abscheidung der Mehrlagen- und/oder Gradientenschicht eine Abscheidung wenigstens einer Aluminiumoxidschicht umfasst. Aluminiumoxid ist ein interessantes Schichtmaterial, das sich bei richtiger Abscheidung durch hervorragende optische und chemische Eigenschaften auszeichnet. Durch die Abscheidung der Aluminiumoxidschicht als Bestandteil einer Mehrlagenschicht und/oder einer Gradientenschicht auf der oxidierten Substratoberfläche können vorteilhafte Eigenschaften der Aluminiumoxidschicht in Zusammenhang mit den anderen Lagen der jeweiligen Schicht realisiert werden.

In einer vorteilhaften Variante des erfindungsgemäßen Verfahrens wird bei der Plasmaoxidation auf dem Substrat eine Oberflächenoxidschicht mit einer Schichtdicke von maximal 3 nm erzeugt darauf eine Aluminiumoxidschicht mit einer Schichtdicke von 20 nm bis 100 nm erzeugt und auf der Aluminiumoxidschicht, Siliziumoxid, Siliziumnitrid oder Siliziumoxinitrid mit einer Schichtdicke von 30 nm bis 150 nm abgeschieden. Ein Schichtstapel mit dem genannten Aufbau hat sich im Anwendungstest als besonders günstig erwiesen, da hier die günstigen Eigenschaften der drei Teilschichten optimal kombiniert werden.

In einem weiteren Ausführungsbeispiel der vorliegenden Erfindung wird die Mehrlagenschicht aus wenigstens zwei Schichten ausgebildet, wobei eine erste, auf dem Substrat abgeschiedene Schicht eine Dotanten enthaltende Quellschicht ist und wobei eine weitere Schicht der Mehrlagenschicht eine Verkapselungsschicht ist, deren optische Eigenschaften auf die der ersten Schicht abgestimmt sind oder werden. Auf diese Weise kann die Quellschicht zur Substratdotierung verwendet werden, wobei als Dotanten beispielsweise Phosphor oder Bor zum Einsatz kommen können. Die Verkapselungsschicht dient als eine die Quellschicht abdeckende Schicht, wobei die Verkapselungsschicht optische Eigenschaften aufweist, die auf die optischen Eigenschaften der ersten Schicht abgestimmt sind.

Insbesondere für die Herstellung von Solarzellen ist es besonders günstig, wenn die wenigstens zwei Schichten, das heißt die Quellschicht und auch die Verkapselungsschicht, Siliziumnitridschichten sind.

Die aus Quellschicht und Verkapselungsschicht ausgebildete Mehrlagenschicht kann sowohl auf der Vorderseite als auch auf der Rückseite des Substrates abgeschieden werden. Die Abscheidung kann dabei zeitgleich oder auch nacheinander erfolgen.

Bevorzugte Ausführungsformen der vorliegenden Erfindung, deren Aufbau, Funktion und Vorteile werden im Folgenden anhand der Figuren der Zeichnung näher erläutert, wobei
- Figur 1: schematisch einen möglichen Aufbau einer Prozesskammer einer Inline-Plasmabeschichtungsanlage zeigt, welche zur Ausführung des erfindungsgemäßen Verfahrens verwendet werden kann;
- Figur 2: schematisch eine mögliche Prozessabfolge einer Ausführungsform des erfindungsgemäßen Verfahrens zeigt;
- Figur 3: schematisch ein Beispiel eines mit Hilfe des Prozessablaufes aus Figur 2 beschichteten Substrates zeigt;
- Figur 4: schematisch den Zusammenhang zwischen Beschichtungsrate, Brechungsindex und effektiver Mikrowellenleistung zeigt, der bei dem erfindungsgemäßen Verfahren genutzt wird;
- Figur 5: schematisch einen weiteren möglichen Prozessablauf gemäß einer weiteren Ausführungsform des erfindungsgemäßen Verfahrens zeigt; und
- Figur 6: schematisch ein mit Hilfe des Prozessablaufes aus Figur 5 beschichtetes Substrat zeigt.

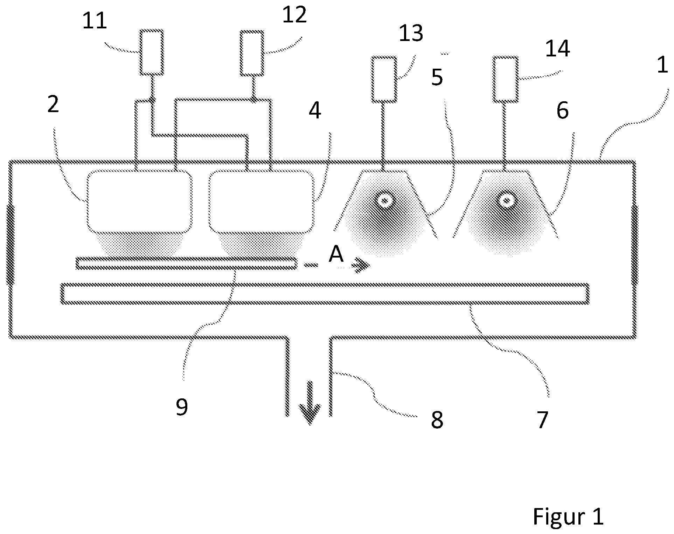

Fig. 1 zeigt schematisch eine mögliche Ausführungsform einer Prozesskammer 1 einer Inline-Plasmabeschichtungsanlage, die sich zur Ausführung des erfindungsgemäßen Verfahrens eignet. Die Prozesskammer 1 ist eine Prozesskammer zur plasmaunterstützten chemischen Gasphasenabscheidung (PECVD). Vor und/oder nach der Prozesskammer 1 können weitere Prozesskammern und/oder andere Kammern oder Schleusen der Inline-Plasmabeschichtungsanlage vorgesehen sein.

Durch die Prozesskammer 1 wird wenigstens ein Substrat 9 entsprechend der durch den Pfeil A gekennzeichneten Durchlaufrichtung durch die Prozesskammer 1 bewegt, wobei während des Durchtransportes des Substrates 9 durch die Prozesskammer 1 eine Beschichtung des Substrates 9 mit einer Mehrlagenschicht und/oder einer Gradientenschicht erfolgt. Hierfür wird das Substrat 9 unter wenigstens zwei Plasmaquellen bzw. in der gezeigten Darstellung unter Gruppen von Plasmaquellen 2, 4 bzw. 5, 6 hindurchgeführt, wobei die Plasmaquellen 2, 4 bzw. 5, 6 mit unterschiedlichen Prozessbedingungen betrieben werden. Die Auswahl der Plasmaquellen und deren Anzahl kann den technologischen Erfordernissen angepasst werden.

In dem in Fig. 1 gezeigten Ausführungsbeispiel sind die Plasmaquellen 2, 4 bzw. 5, 6 unterschiedlichen Typs bzw. konstruktiv unterschiedliche Plasmaquellen. Die Plasmaquellen 2, 4 sind beispielsweise RF-Plasmaquellen oder ICP-Plasmaquellen, die mit elektrischer Leistung relativ niedriger Frequenz versorgt werden, wobei unter niedrigen Frequenzen ein Bereich von Gleichstrom bis 100 MHz zu verstehen ist. Vorzugsweise verwenden die Plasmaquellen 2, 4 eine zugelassene Frequenz in einem Bereich von 10 KHz bis 13,56 MHz. Die Plasmaquellen 5, 6 sind in dem gezeigten Beispiel Mikrowellenplasmaquellen und arbeiten mit Frequenzen zwischen 100 MHz und mehreren GHz, wobei bevorzugte Frequenzen 915 MHz oder 2,45 GHz sind.

Um die erfindungsgemäß eingesetzten Plasmaquellen in einer Prozesskammer bei unterschiedlichen Prozessbedingungen betreiben zu können, können, wie in Fig. 1 gezeigt, sich die Plasmaquellen konstruktiv, das heißt hinsichtlich ihres Typs, unterscheiden. Es können jedoch auch funktionelle Unterschiede zwischen den Plasmaquellen bzw. Unterschiede im Hinblick auf die Betriebsart oder Betriebsbedingungen bei ansonsten gleichem Aufbau der Plasmaquellen vorliegen.

Beispielsweise können die in der Prozesskammer 1 verwendeten Plasmaquellen 2, 4 bzw. 5, 6 sich allein dadurch unterscheiden, dass sie bei unterschiedlichen elektrischen Betriebsbedingungen betrieben werden. Unter unterschiedlichen elektrischen Betriebsbedingungen ist hierbei ein Verwenden unterschiedlicher Plasmaanregungsfrequenzen, unterschiedlicher effektiver elektrischer Leistungen und/oder unterschiedlicher Pulsparameter zu verstehen. Dabei umfasst das Verwenden unterschiedlicher Pulsparameter ein Verwenden unterschiedlicher Pulsfrequenzen, Peakleistungen, Einschaltdauern der Pulse, Ausschaltdauern der Pulse, die Synchronisation der Plasmaquellen, die Phasengleichheit und/oder den Phasenversatz der Plasmaquellen. Mit Hilfe solcher Parameter besteht die Möglichkeit, Einfluss auf die entstehenden Gasfragmente im Plasma zu nehmen, die Zusammensetzung des Plasmas zu steuern und die Konzentration von Gasfragmenten zu beeinflussen. Des Weiteren kann mit den elektrischen Betriebsbedingungen der eingesetzten Plasmaquellen Einfluss auf die Wechselwirkung des Plasmas mit der Substratoberfläche genommen werden.

Die unterschiedlichen elektrischen Betriebsbedingungen führen dazu, dass die Plasmaquellen einen großen Einfluss auf die Schichtzusammensetzung, an die speziellen Schichtwachstumsprozesse der Lagen einer Mehrlagenschicht und/oder des Schichtaufbaus einer Gradientenschicht und damit auch auf die Eigenschaften der hergestellten Schichten haben.

Jede der einzelnen Plasmaquellen 2, 4, 5, 6 der beispielhaft gezeigten Prozesskammer 1 besitzt mindestens einen Gasanschluss 11, 12, 13, 14 zur Zufuhr von Prozessgasen. Innerhalb jeder Plasmaquelle 2, 4, 5, 6 kann wenigstens eine Gasdusche, die hier nicht dargestellt ist, der Gasverteilung dienen. Für jede der Plasmaquellen 2, 4, 5, 6 können die Gaszuflüsse sowie die elektrischen Betriebsbedingungen der Plasmaquellen separat eingestellt oder geregelt werden.

Wie bereits oben erwähnt, sind in der Ausführungsform von Fig. 1 jeweils zwei Plasmaquellen 2, 4 bzw. 5, 6 unterschiedlichen Typs vorhanden, die paarweise angeordnet sind und gruppenweise betrieben werden. Dabei werden die Plasmaquellen 2, 4 bzw. 5, 6 einer Gruppe mit jeweils gleichen Prozessbedingungen betrieben.

Darüber hinaus können die Bearbeitungsgebiete der Plasmaquellengruppen durch hier nicht gezeigte Leitwertblenden voneinander abgegrenzt werden. Zusätzlich kann eine Abgrenzung der jeweiligen Bearbeitungsbereiche durch separate Gasabsaugungen für jeden Bearbeitungsbereich im oberen Bereich der Prozesskammer 1 erreicht werden.

Die Prozesskammer 1 ist eine Vakuumkammer, die in der Regel bei Vakuum oder Unterdruck betrieben wird. Hierfür ist die Prozesskammer 1 in Transportrichtung der Substrate 9 jeweils hier nicht separat gekennzeichnete Vakuumventile begrenzt. Ferner besitzt die Prozesskammer wenigstens einen Saugstutzen 8 für den Anschluss einer Vakuumpumpe.

Für den Substrattransport durch die Prozesskammer 1 wird ein Transportsystem verwendet, das der besseren Übersichtlichkeit halber in Fig. 1 nicht separat dargestellt ist. Geeignete Transportsysteme sind zum Beispiel Rollentransportsysteme oder Transportsysteme mit Linearmotoren. Das Transportsystem dient einem kontinuierlichen oder auch diskontinuierlichen Transport der Substrate 9 durch die Prozesskammern der Inline-Plasmabeschichtungsanlage. Dabei können die Transportrichtungen und -geschwindigkeiten der Substrate 9 bei der vorliegenden Erfindung den jeweiligen technologischen Erfordernissen und den gewünschten Eigenschaften der herzustellenden Schichten oder Schichtfolgen angepasst werden. Neben der typischen linearen Bewegung kann bei dem erfindungsgemäßen Verfahren im Bereich der Oberflächenbearbeitung auch eine oszillierende bidirektionale Bewegung der Substrate 9 ausgeführt werden. Großflächige Substrate 9 können direkt von dem Transportsystem durch die Prozesskammer 1 bewegt werden. Zur Beschichtung von Substraten 9 mit kleinen Abmessungen können auch Substratträger bzw. Carrier verwendet werden, die eine Vielzahl von Substraten 9 aufnehmen können. In Abhängigkeit von dem konkreten Transportsystem können auch durchgehende Folien oder Bänder kontinuierlich oder diskontinuierlich durch die Prozesskammer 1 bewegt werden.

Wie aus Fig. 1 ferner hervorgeht, weist die Prozesskammer 1 eine unterhalb der Substrate 9 vorgesehene Heizvorrichtung 7 auf, die der Temperierung der Substrate dient, wobei die Substrate 9 bei dem erfindungsgemäßen Verfahren bei gleicher definierter Substrattemperatur von maximal 600ºC beschichtet werden.

Zur Ausführung des erfindungsgemäßen Verfahrens werden die Substrate 9 oder die Substratträger mit Substraten 9 durch ein geöffnetes Vakuumventil aus einer in Fig. 1 nicht dargestellten Einschleusekammer in die über den Saugstutzen 8 evakuierte Prozesskammer 1 entsprechend der durch den Pfeil A gezeigten Transportrichtung A bewegt.

Einschleusekammern und Ausschleusekammern an der Prozesskammer 1 ermöglichen den Transport der Substrate 9 zwischen Atmosphäre und Vakuum. Ferner sind zusätzliche Trennkammern dann notwendig, wenn mehrere Prozesskammern der Inline-Plasmabeschichtungsanlage mit sehr unterschiedlichen Bearbeitungstechnologien zueinander getrennt werden müssen, um zum Beispiel eine Gasverschleppung zwischen den Prozesskammern zu verhindern.

Wie oben bereits ausgeführt, kann der Transport der Substrate 9 auch zumindest teilweise gegenläufig zu der Transportrichtung A oder oszillierend erfolgen. Bei dem Durchtransport der Substrate 9 werden diese durch die Heizvorrichtung 7 auf einer definierten, gleichbleibenden Substrattemperatur zwischen 20ºC und 600ºC gehalten.

In der Prozesskammer 1 können alle prozessrelevanten Parameter, wie der Gasdurchfluss, das Mischungsverhältnis der eingesetzten Gase sowie die elektrischen Betriebsbedingungen der einzelnen Plasmaquellen 2, 4, 5, 6, getrennt und unabhängig eingestellt werden. Ein unterschiedlicher Gasdruck in den einzelnen Plasmaquellen 2, 4, ,5, 6 ist dabei nicht ohne Weiteres möglich, da in einer gemeinsamen Prozesskammer 1 Gasdruckunterschiede nur durch entsprechend definierte Strömungsleitwerte zwischen den Plasmaquellen und ein getrenntes Abpumpen der Gase im Bereich jeder Plasmaquelle erreicht werden könnten. Aber auch die Einstellung unterschiedlicher Gasmischungen bzw. Gasflüsse der eingesetzten Gase ist zwischen benachbarten Plasmaquellen nur eingeschränkt möglich, da es zwischen den einzelnen Plasmaquellen zu einem schnellen Gasaustausch durch Gasdiffusion kommt und deshalb eine gegenseitige Prozesstrennung nur schwer möglich ist. Erfindungsgemäß werden deshalb die einzelnen, in der Prozesskammer 1 nacheinander angeordneten Plasmaquellen 2, 4, 5, 6 mit unterschiedlichen Prozessbedingungen betrieben, wobei bevorzugt elektrische Betriebsbedingungen zueinander unterschiedlich eingestellt werden.

Hierbei hat die verwendete Plasmaanregungsfrequenz einen besonders großen Einfluss auf die Prozessbedingungen. So haben zum Beispiel Plasmen mit niedrigerer Plasmaanregungsfrequenz normalerweise eine höherenergetische Wechselwirkung der Ladungsträger mit der Substratoberfläche zur Folge als Plasmen, die mit hohen Anregungsfrequenzen betrieben werden. Dadurch kann zum Beispiel die Anzahl niederenergetischer Bindungen während des Schichtwachstums reduziert werden und damit höherenergetische Bindungen angereichert werden.

Bei Plasmen mit hohen Anregungsfrequenzen wiederum ist es vorteilhaft, dass diese höhere Plasmadichten erreichen können und damit eine höhere und intensivere Dissoziation der verwendeten Prozessgase ermöglichen. Solche Plasmen sind deshalb besonders für Hochrateprozesse geeignet. Durch eine definierte Auswahl und Anordnung von Plasmaquellen mit niedriger Plasmaanregungsfrequenz und Plasmaquellen mit höheren Plasmaanregungsfrequenzen können in der Prozesskammer 1 verschiedene Beschichtungstechnologien besonders vorteilhaft gestaltet werden.

Werden zur Plasmaanregung in den Plasmaquellen 2, 4, 5, 6 pulsbare Generatoren für die Bereitstellung der elektrischen Versorgungsleistungen verwendet, so können damit weitere technologische Vorteile erreicht werden. So können durch eine definierte Wahl von Pulspeakleistung, Zeitdauer der Plasmaanregung bzw. durch eine geeignete Wahl der Pulsfrequenz zum Beispiel plasmachemische Stoffumwandlungsreaktionen im Plasma in einem weiten Bereich beeinflusst werden. Besonders geeignete Plasmaquellen für den gepulsten Betrieb der erzeugten Plasmen sind lineare Mikrowellenplasmaquellen. Die Plasmaanregungsfrequenz ist dabei vorteilhaft 915 MHz oder 2,45 GHz.

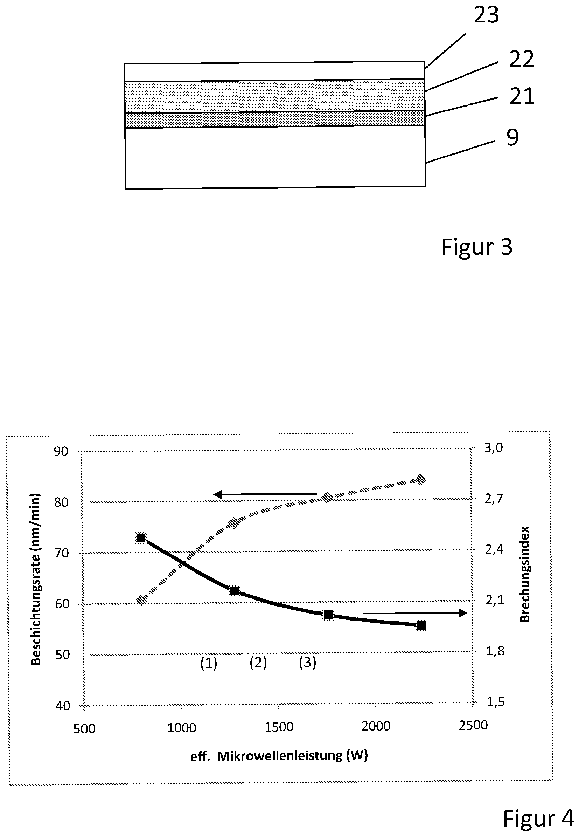

So bewegen sich bei dem Durchtransport durch die Prozesskammer 1 die Substrate 9 zunächst unter den Plasmaquellen 2, 4 hindurch. Danach werden die Substrate 9 unter den sich von den Plasmaquellen 2, 4 unterscheidenden Plasmaquellen 5, 6 hindurchgeführt. Dabei kann durch die Plasmaquellen 2, 4 beispielsweise eine in Fig. 3 dargestellte siliziumreiche Siliziumnitridschicht 21 mit einem hohen Wasserstoffanteil und einer geringen Dichte, bei welcher diese Schicht durchlässig für Wasserstoff ist, auf dem Substrat 9 abgeschieden werden. Durch die Plasmaquellen 5, 6 kann daraufhin unmittelbar anschließend in der gleichen Prozesskammer 1 eine zweite Siliziumnitridschicht 22 mit anderen Schichteigenschaften als die der ersten Siliziumnitridschicht 21 erzeugt werden. Beispielsweise kann als zweite Siliziumnitridschicht 22 eine etwa stöchiometrische Si₃N₄-Schicht mit geringen optischen Verlusten und einem hohen Wasserstoffanteil, der als Wasserstoffquelle für die Volumenpassivierung des Halbleiters dient, abgeschieden werden.

Daraufhin werden die Substrate 9, wiederum über entsprechende Vakuumventile und Schleusen, eventuell weiteren Prozesskammern der Inline-Plasmabeschichtungsanlage zugeführt, die in Fig. 1 nicht dargestellt sind.

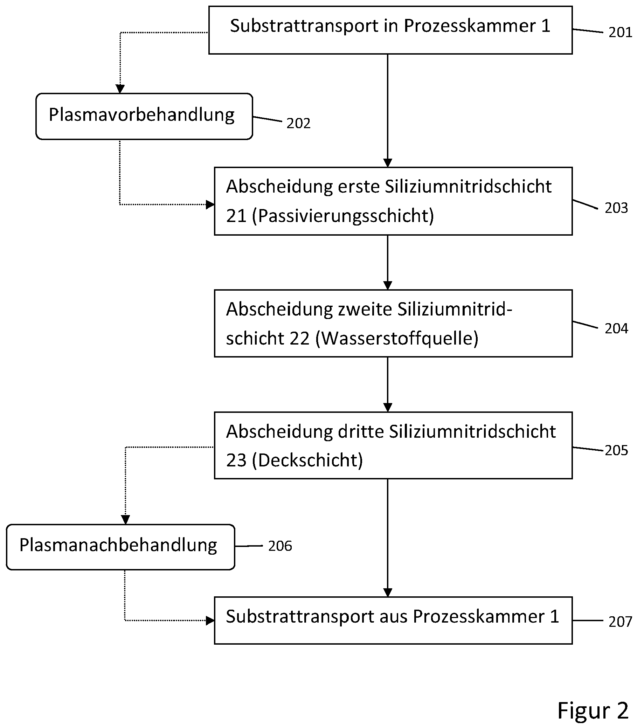

Neben den oben beschriebenen Plasmaquellen zur Abscheidung von Mehrlagenschichten können weitere Plasmaquellen, zum Beispiel, wie in Fig. 2 gezeigt, zur Substratvorbehandlung, vor den Beschichtungsquellen 2, 4, 5, 6 oder auch zur Substratnachbehandlung nach den Beschichtungsquellen 2, 4, 5, 6 angeordnet sein.

Fig. 2 zeigt schematisch einen möglichen Prozessablauf einer Ausführungsform des erfindungsgemäßen Verfahrens. Hierbei wird in einem Schritt 201 wenigstens ein Substrat 9 in eine Prozesskammer 1 transportiert. In der Prozesskammer 1 wird das wenigstens eine Substrat 9 kontinuierlich oder diskontinuierlich unter bei unterschiedlichen Prozessbedingungen arbeitenden Plasmaquellen durchgeführt.

Dabei kann optional durch wenigstens eine, zu Beginn des Durchtranportes der Substrate 9 durch die Prozesskammer 1 vorgesehene Plasmaquelle eine Plasmavorbehandlung in einem Schritt 202 erfolgen. Durch die Plasmavorbehandlung kann die Substratoberfläche der Substrate 9 gereinigt, voraktiviert und/oder die Substratoberfläche mit Hilfe einer Plasmaoxidation oxidiert werden. In derartigen Plasmaquellen zur Plasmavorbehandlung werden meistens nicht Schicht bildende Gase eingesetzt. Zur Vorbehandlung der Substrate kann auch eine zusätzliche Prozesskammer verwendet werden. Diese Prozesskammer sollte direkt vor der eigentlichen Beschichtungskammer bzw. der Prozesskammer 1 angeordnet sein.

Daraufhin oder direkt nach dem Transport der Substrate 9 in die Prozesskammer 1 erfolgt in dem Verfahrensbeispiel aus Fig. 2 eine Abscheidung einer ersten Siliziumnitridschicht 21 im Schritt 203. Die erste Siliziumnitridschicht 21 kann, wie oben besprochen, eine etwa 5 nm bis 20 nm dicke siliziumreiche Siliziumnitridschicht mit einem hohen Wasserstoffanteil und einer geringen Si-N-Dichte sein, bei welcher diese Schicht durchlässig für Wasserstoff ist, sodass sich diese Schicht besonders als Passivierungsschicht auf den Substraten 9 eignet. Durch die geringe Schichtdicke dieser Schicht wird zudem gewährleistet, dass die Absorptionsverluste der hochbrechenden Siliziumnitridschicht 21 vernachlässigt werden können.

In einem weiteren Schritt 204 wird nachfolgend eine zweite Siliziumnitridschicht 22 auf der ersten Siliziumnitridschicht 21 abgeschieden. Die Abscheidung der zweiten Siliziumnitridschicht erfolgt unter mit anderen Prozessbedingungen betriebenen Plasmaquellen als die Abscheidung der ersten Siliziumnitridschicht. Als zweite Siliziumnitridschicht kann beispielsweise eine etwa stöchiometrische Si₃N₄-Schicht mit etwa drei bis viermal so großer Dicke wie die der ersten Siliziumnitridschicht 21 abgeschieden werden. Vorzugsweise weist die zweite Siliziumnitridschicht geringe optische Verluste und einen hohen Wasserstoffanteil auf, sodass sich diese Schicht als Wasserstoffquelle für die Volumenpassivierung des Halbleitersubstrates eignet.

Nachfolgend wird in einem Schritt 205 eine dritte Siliziumnitridschicht 23 auf der zweiten Siliziumnitridschicht 22 ausgebildet. Die dritte Siliziumnitridschicht 23 ist in dem gezeigten Ausführungsbeispiel eine hochdichte a-SiN:H-Schicht, deren Zusammensetzung ein Maximum an Si-N-Bindungen aufweist. Die dritte Siliziumnitridschicht 23 dient als Deckschicht und als Diffusionsbarriere, wobei sie die Abgabe des Wasserstoffes an die Atmosphäre behindern soll. Die Dicke der dritten Siliziumnitridschicht 23 sowie deren Brechungsindex werden gerade so gewählt, dass die Summe der Schichtdicken der Einzelschichten und das Integral der Brechungsindizes die gewünschte Entspiegelung einer Solarzelle gewährleisten kann.

Im Anschluss an die Abscheidung der Deckschicht 23 kann in einem optional nachgeschalteten Schritt in der gleichen Prozesskammer 1 eine Plasmanachbehandlung vorgenommen werden. Die Substratnachbehandlung besitzt technologische Vorteile. Zum Beispiel kann damit eine schnelle Sättigung von freien Bindungen unmittelbar nach der Abscheidung der Mehrlagen- oder Gradientenschicht erreicht werden. Ist es für die Substratnachbehandlung technologisch erforderlich, dass Gase eingesetzt werden, die den Beschichtungsprozess negativ beeinflussen würden, so kann nach der Beschichtungskammer bzw. der Prozesskammer 1 auch eine separate Nachbehandlungskammer vorgesehen werden.

Daraufhin erfolgt ein Austransport der Substrate 9 aus der Prozesskammer 1.

Fig. 3 zeigt schematisch ein mit der Verfahrensvariante aus Fig. 2 beschichtetes Substrat 9, auf welchem die erste Siliziumnitridschicht 21 als Passivierungsschicht, darauf die zweite Siliziumnitridschicht 22 als Wasserstoffquelle und abschließend die dritte Siliziumnitridschicht als Deckschicht abgeschieden ist.

Der in Fig. 3 dargestellte Schichtstapel kann mit Hilfe einer Prozesskammer ausgebildet werden, die ähnlich wie die Prozesskammer 1 aus Fig. 1 aufgebaut ist. Die Einstellung der gewünschten Substrattemperatur wird in einer solchen Kammer mit Hilfe von mehreren Heizungen während des kontinuierlichen bzw. diskontinuierlichen Substrattransportes erreicht. Für die notwendigen Schichteigenschaften der Siliziumnitridschichten ist ein Temperaturbereich zwischen 300ºC und 500ºC vorteilhaft. In der einzusetzenden Prozesskammer sind wenigstens drei Plasmaquellen vorzusehen, die in Transportrichtung der Substrate 9 nacheinander angeordnet sind. Diese Plasmaquellen können gleiche Plasmaquellen sein. Beispielsweise kommen hierfür lineare Mikrowellenplasmaquellen mit einer Anregungsfrequenz von 2,45 GHz in Betracht. Die drei Plasmaquellen besitzen jeweils eine eigene Gas- und elektrische Versorgung. Jede der einzelnen Plasmaquellen besitzt dabei zwei getrennte Gasduschen. Eine Gasdusche ist substratnah und die andere nahe der Plasmaerzeugung angeordnet.

In die substratnahen Gasduschen der Plasmaquellen wird das Gas Silan eingelassen und in die plasmanahen Gasduschen zum Beispiel Ammoniak oder Stickstoff. Für den Beschichtungsprozess wird in der vorzusehenden Prozesskammer ein Prozessdruck von ca. 5 Pa bis etwa 30 Pa eingestellt. Alle Plasmaquellen werden mit gleichem Gesamtgasfluss und Gasverhältnis betrieben.

Zur Erreichung der erforderlichen unterschiedlichen Schichteigenschaften für jede Einzelschicht 21, 22, 23 wird jede einzelne Plasmaquelle mit einer unterschiedlichen effektiven Mikrowellenleistung betrieben. Die unterschiedlichen effektiven Mikrowellenleistungen werden dadurch erreicht, dass unterschiedliche definierte Pulspeakleistungen und unterschiedliche definierte Zeitdauern der Puls-An-Zeit gewählt werden.

Fig. 4 zeigt anhand eines Diagramms den Zusammenhang zwischen Beschichtungsrate, effektiver Mikrowellenleistung einer Plasmaquelle und dem Brechungsindex der jeweils erzeugten Schicht. Wie aus dieser Darstellung ersichtlich ist, wächst die Beschichtungsrate mit steigender Mikrowellenleistung, wobei der Brechungsindex der jeweils erzeugten Schicht mit zunehmender Leistung sinkt. Dieser Effekt wird in dem erfindungsgemäßen Verfahren genutzt, wobei durch gezielte Einstellung der Leistung einer Plasmaquelle nicht nur die Schichtdicke sondern auch der Brechungsindex der jeweiligen Schicht oder Schichtlage eingestellt werden kann.

Wie bereits oben erwähnt, ist es manchmal erforderlich, einen Kompromiss zwischen notwendigen Schichteigenschaften und einer geforderten Beschichtungsrate zu finden. Eine einfache Steigerung der Beschichtungsrate, zum Beispiel durch Erhöhen der eingesetzten Versorgungsleistung, führt oft zur Verschlechterung von wichtigen Schichteigenschaften. Auch kommt es häufig vor, dass mit steigender Beschichtungsrate die Schichten poröser werden und die Rauigkeit der Schichten zunimmt. Stöchiometriefehler und Stapelfehler können dabei ebenfalls stark zunehmen. Solche Schichten sind für eine konforme Beschichtung zum Beispiel auf texturierten Oberflächen weniger geeignet.

Prinzipiell kann zwar auch die Anzahl der Beschichtungsquellen erhöht werden, um einen höheren Durchsatz zu erreichen, aber dies ist meistens uneffektiv und kostspielig. Häufig ist es nicht notwendig, die geforderten Schichteigenschaften für die gesamte Schichtdicke der Antireflexionsschicht bereit zu stellen. So werden zum Beispiel an die Schichtbereiche, die sich näher an der verwendeten Zellenoberfläche befinden, komplexere Anforderungen gestellt als an die weiter entfernteren Schichtbereiche. Normalerweise reichen wenige nanometerdicke Schichtdicke aus, um alle wichtigen Forderungen an die Schichtfunktion erfüllen zu können. Für eine relativ dünne erste Schicht, die nicht mehr als ca. ein Viertel der Gesamtschichtdicke betragen muss, ist es dann auch nicht entscheidend, wenn sie mit niedrigen Beschichtungsraten aufgebracht wird. Die restlichen drei Viertel der Gesamtschichtdicke können dann mit deutlich höheren Beschichtungsraten aufgebracht werden, da im Wesentlichen nur noch Anforderungen an die optischen Eigenschaften des Gesamtstapels bestehen.

So können in einem weiteren Ausführungsbeispiel des erfindungsgemäßen Verfahrens unterschiedliche Plasmaquellen in einer Prozesskammer eingesetzt werden, wobei die Plasmaquellen wenigstens eine lineare RF-Plasmaquelle mit Plasmaanregungsfrequenz von 13,56 MHz und vorzugsweise mehrere lineare Mikrowellenplasmaquellen mit einer Plasmaanregungsfrequenz von 2,45 GHz umfassen. Die Plasmaquellen besitzen bevorzugt jeweils eine eigene Gasversorgung als auch eine eigene elektrische Leistungsversorgung. Der Prozessdruck in der Prozesskammer wird bei dieser Ausführungsvariante des erfindungsgemäßen Verfahrens in einem Bereich von 5 Pa bis etwa 50 Pa eingestellt. Als Prozessgase sollen wieder Silan und Ammoniak verwendet werden. Das Mischungsverhältnis und der Teilgasfluss der Gase der einzelnen Plasmaquellen werden dabei so angepasst, dass bei einer optimierten Hochfrequenzleistung eine erste dichte Schicht, zum Beispiel mit einer Si-N-Bindungsdichte von ca. 1,2 x 10⁻²³ cm⁻³, erhalten wird.

Bei diesem Ausführungsbeispiel des erfindungsgemäßen Verfahrens wird die Transportgeschwindigkeit der Substrate so gewählt, dass dabei die gewünschte Schichtdicke erreicht wird. Die Teilgasflüsse und die effektiven Mikrowellenleistungen der weiteren Plasmaquellen werden anschließend so optimiert, dass durch diese eine zweite Siliziumnitridschicht abgeschieden wird, mit der die gewünschte Gesamtschichtdicke des Schichtstapels erreicht wird. Die Gesamtschichtdicke ergibt sich aus den optischen Anforderungen der Antireflexionsschicht und dem Brechungsindex der jeweiligen Einzelschichten

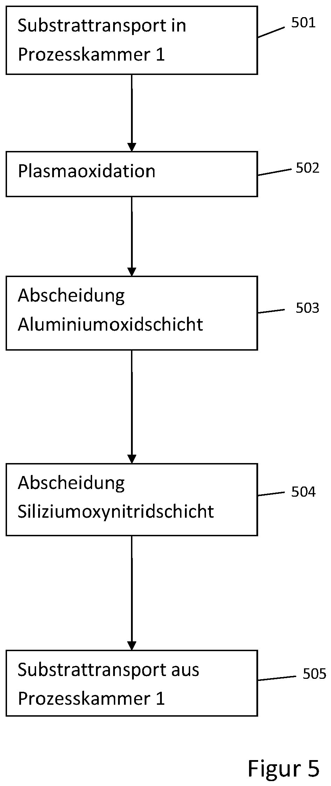

Fig. 5 zeigt schematisch eine weitere Prozessfolge zur Ausführung des erfindungsgemäßen Verfahrens. Hierbei erfolgt zunächst, ähnlich wie in dem Verfahren von Fig. 2, in Schritt 501 ein Transport wenigstens eines Substrates 9 in die Prozesskammer 1. Daraufhin wird in einem Schritt 502 mittels einer ersten Plasmaquelle oder einer ersten Gruppe von Plasmaquellen in der Prozesskammer 1 in Durchlaufrichtung der Substrate 9 eine Plasmaoxidation der Substratoberfläche durchgeführt. Die Plasmaoxidation erfolgt vorzugsweise in einem N₂O-Plasma, wobei ein Oberflächenoxid 31 mit einer Dicke erzeugt wird, die typischerweise 3 nm nicht übersteigt. Das Oberflächenoxid 31 dient dazu, die Oberflächenzustände minimal zu halten.

Daraufhin wird in einem Schritt 502 eine Aluminiumoxidschicht 32 durch eine weitere Plasmaquelle oder eine weitere Gruppe von Plasmaquellen innerhalb der gleichen Prozesskammer 1 auf das auf dem Substrat 9 erzeugte Oberflächenoxid 31 abgeschieden. Die Dicke der Aluminiumoxidschicht 32 beträgt zwischen 20 nm und 100 nm, vorzugsweise 50 nm.

Nachfolgend wird in einem Schritt 504 auf die Aluminiumoxidschicht 32 eine Siliziumoxynitridschicht 33 abgeschieden, deren Dicke zwischen 30 nm und 150 nm, vorzugsweise 90 nm, beträgt. Anstelle der hier beispielhaft aufgeführten Siliziumoxynitridschicht 33 können in anderen, nicht gezeigten Ausführungsvarianten der vorliegenden Erfindung auch eine Siliziumoxidschicht oder eine Siliziumnitridschicht auf dem Aluminiumoxid 32 abgeschieden werden.

Während der in den Schritten 502 bis 504 durchgeführten Prozessschritte beträgt die Substrattemperatur der durch die Prozesskammer 1 durchgeführten Substrate 9 zwischen 100ºC und 400ºC, vorzugsweise 250ºC.

Für die Schritte 502 bis 504 werden vorzugsweise lineare Mikrowellen-Plasmaquellen eingesetzt, wobei die Frequenz der Plasmapulsung für die einzelnen erzeugten Teilschichten verschieden eingestellt wird. Die Pulsung der Plasmaquellen während des Plasmaoxidationsschrittes 502 beträgt weniger als 35 Hz, vorzugsweise 30 Hz. Die Pulsung der AL₂O₃-Quellen im Schritt 503 beträgt mehr als 45 Hz, vorzugsweise 50 Hz. Die Pulsung der abschließenden Oxid-/Nitridbeschichtung im Schritt 504 beträgt zwischen 35 und 45 Hz, vorzugsweise 40 Hz.

Bei den Prozessschritten 502 bis 504 werden die Quellenblöcke der Prozesskammer 1 mit jeweils verschiedener Leistung betrieben. Die Plasmaleistung im Oxidationsschritt 502 beträgt weniger als 1000 W je Quelle. Die Leistung der Al₂O₃-Quellen im Schritt 503 liegt zwischen 1000 W und 2000 W, vorzugsweise 1500 W. Die Plasmaleistung der Siliziumoxid-/-nitridquellen im Schritt 504 beträgt mehr als 2500 W, vorzugsweise mehr als 3000 W.

Nach dem Schritt 504 werden die Substrate 9 aus der Prozesskammer 1 heraus transportiert. In anderen, nicht gezeigten Ausführungsvarianten der vorliegenden Erfindung kann zwischen der Siliziumoxynitridabscheidung in Schritt 504 und dem Austransport der Substrate 9 in Schritt 505 auch noch eine Plasmanachbehandlung durchgeführt werden.

Im Ergebnis entstehen auf den Substraten 9 Mehrlagenschichten, die wenigstens eine Aluminiumoxidschicht 32 beinhalten und die sich bevorzugt zur Rückseitenpassivierung von Siliziumsolarzellensubstraten eignen. Die erfindungsgemäße Verfahrensabfolge besitzt dabei den Vorteil, dass die Schichtfolge mit hoher Qualität der Einzelschichten in einer einzigen Prozesskammer 1 hergestellt werden kann, wobei bei der Herstellung des Schichtstapels die Substrate 9 durch die Prozesskammer 1 hindurchbewegt werden, sodass eine kontinuierliche Prozessierung der Substrate 9 in der Prozesskammer 1 erfolgt. Entsprechend können mit dem erfindungsgemäßen Verfahren sehr hohe Durchsätze erreicht werden.

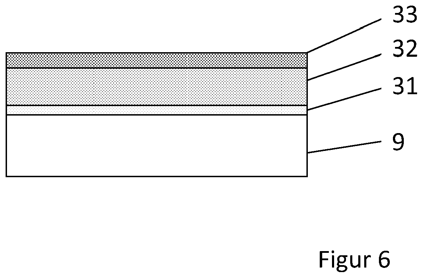

Fig. 6 zeigt schematisch den Aufbau eines mit dem Verfahren aus Fig. 5 beschichteten Substrates 9. Dabei ist auf dem Substrat 9 das durch Plasmaoxidation erzeugte Oberflächenoxid 31 vorgesehen. Auf dem Oberflächenoxid 31 ist die in dem Schritt 502 erzeugte Aluminiumoxidschicht 32 abgeschieden, auf welcher die Siliziumoxynitridschicht 33, die in Schritt 504 aus Fig. 5 erzeugt wurde, abgeschieden ist.

In einem weiteren möglichen Ausführungsbeispiel der vorliegenden Erfindung kann das erfindungsgemäße Verfahren auch zur Herstellung von Mehrlagenschichten verwendet werden, die wenigstens eine auf dem Substrat 9 abgeschiedene, Dotanten enthaltende Quellschicht und eine direkt oder indirekt darauf abgeschiedene Verkapselungsschicht aufweisen. Als Quellschicht kann beispielsweise eine phosphordotierte Siliziumnitridschicht mit einer Dicke zwischen 10 nm und 30 nm abgeschieden werden. Die Phosphordotierung kann beispielsweise 5% betragen. Anstelle von Phosphor können jedoch auch andere geeignete Dotanten, wie beispielsweise Bor, zum Einsatz kommen. Als Verkapselungsschicht kann beispielsweise eine Standard-ARC-Siliziumnitridschicht mit einer Dicke zwischen 50 nm und 70 nm verwendet werden, deren Brechungsindex bei 2,1 ± 0,1 liegt. Die aus wenigstens der Quellschicht und der Verkapselungsschicht aufgebaute Mehrlagenschicht kann sowohl auf der Vorderseite als auch auf der Rückseite des Substrates 9 abgeschieden werden. Die Abscheidung auf Vorder- und Rückseite kann zeitgleich als auch nacheinander vorgenommen werden.

Mit dem erfindungsgemäßen Verfahren lassen sich ganz unterschiedliche mehrlagige Schichtstapel oder auch Gradientenschichten herstellen. Für das erfindungsgemäße Verfahren ist typisch, dass die Abscheidung von dünnen Schichten mit Hilfe plasmachemischer Dampfabscheidungsprozesse erfolgt und dass die Substratbewegung während der Abscheidung kontinuierlich durchgeführt wird. Die Substrate 9 werden dabei kontinuierlich durch die Bearbeitungsgebiete von wenigstens zwei, in Transportrichtung nacheinander angeordneten Plasmaquellen 2, 4, 5, 6 bewegt. Die wenigstens zwei Plasmaquellen befinden sich innerhalb einer einzigen Prozesskammer 1 und werden mit unterschiedlichen Prozessbedingungen betrieben. Die Substratausrichtung in Bezug auf die Plasmaquellen 2, 4, 5, 6 ist dabei nach den technologischen Erfordernissen frei wählbar. So kann die Substratbearbeitung sowohl "face-down" oder "face-up" erfolgen. Neben den beschriebenen Schichtabscheideprozessen lassen sich mit Hilfe des erfindungsgemäßen Verfahrens und den zugehörigen Vorrichtungen auch andere Oberflächenbearbeitungsprozesse, wie zum Beispiel Oberflächenaktivierungen, Oberflächenreinigungen oder auch Oberflächenabtragungsprozesse vorteilhaft realisieren.

## Patentansprüche

1. Verfahren zur Abscheidung von Mehrlagenschichten und/oder Gradientenschichten auf wenigstens ein Substrat (9) in einer Inline-Plasmabeschichtungsanlage mit wenigstens einer Prozesskammer (1), in der wenigstens zwei einzelne Plasmaquellen (2, 4, 5, 6) in Transportrichtung (A) der Substrate (9) nacheinander angeordnet sind, mit plasmaunterstützter chemischer Gasphasenabscheidung, wobei die wenigstens zwei Plasmaquellen (2, 4, 5, 6) mit unterschiedlichen Prozessbedingungen bei Anregungsfrequenzen zwischen 10 kHz und 2,45 GHz betrieben werden und für die wenigstens zwei Plasmaquellen (2, 4, 5, 6) linear skalierbare Plasmaquellen mit eigener Gasversorgung und Leistungsversorgung verwendet werden, wenigstens eine der wenigstens zwei Plasmaquellen dabei gepulst wird und das Substrat (9) kontinuierlich oder diskontinuierlich durch die unterschiedlichen Beschichtungsgebiete der einzelnen Plasmaquellen (2, 4, 5, 6) hindurch transportiert wird, wobei die Bewegung der Substrate (9) linear in der Transportrichtung (A), gegenläufig zu der Transportrichtung (A) oder oszillierend bidirektional ausgeführt wird, und wobei wenigstens ein definierter zweilagiger Schichtstapel mit unterschiedlichen Schichteigenschaften der Einzelschichten (21, 22, 23; 31, 32 33) und/oder wenigstens eine definierte Gradientenschicht auf dem Substrat (9) abgeschieden wird, **dadurch gekennzeichnet, dass** die wenigstens zwei Plasmaquellen (2, 4, 5, 6) mit unterschiedlichen elektrischen Betriebsbedingungen betrieben werden und das Betreiben der wenigstens zwei Plasmaquellen (2, 4, 5, 6) mit unterschiedlichen elektrischen Betriebsbedingungen ein Verwenden unterschiedlicher Plasmaanregungsfrequenzen umfasst.

2. Verfahren nach Anspruch 1, **dadurch gekennzeichnet, dass** die wenigstens zwei Plasmaquellen (2, 4, 5, 6) mit unterschiedlichen Pulsfrequenzen, Peakleistungen und/oder Einschaltdauern der Pulse betrieben werden.

3. Verfahren nach einem der vorhergehenden Ansprüche, **dadurch gekennzeichnet, dass** wenigstens zwei der Plasmaquellen (2, 4; 5, 6) zu einer oder zu mehreren Gruppen zusammengeschaltet werden und die Plasmaquellen einer Gruppe mit gleichen Prozessbedingungen betrieben werden.

4. Verfahren nach einem der vorhergehenden Ansprüche, **dadurch gekennzeichnet, dass** wenigstens eine der zwei Plasmaquellen (2, 4) mit einer Plasmaanregungsfrequenz von 10 kHz bis 300 MHz und wenigstens eine weitere der zwei Plasmaquellen (5, 6) mit einer Plasmaanregungsfrequenz von 100 MHz bis 2,45 GHz betrieben wird.

5. Verfahren nach einem der vorhergehenden Ansprüche, **dadurch gekennzeichnet,** das mit zwischen den einzelnen Plasmaquellen (2, 4, 5, 6) angeordneten Leitwertblenden Gasvermischungen verringert werden.

6. Verfahren nach einem der vorhergehenden Ansprüche, **dadurch gekennzeichnet, dass** die Mehrlagenschicht und/oder die Gradientenschicht eine aus wenigstens zwei Siliziumnitridschichten (21, 22, 23) mit unterschiedlicher Schichtzusammensetzung und Schichtdicke aufgebaute Antireflexionsbeschichtung für kristalline Silizium-Solarzellen ist, wobei eine erste Siliziumnitridschicht (21) derart abgeschieden wird, dass sie als Oberflächenpassivierungsschicht auf dem Substrat wirkt, und eine zweite Siliziumnitridschicht (22) derart auf der ersten Silziumnitridschicht abgeschieden wird, dass sie als Wasserstoffquelle wirkt und gemeinsam mit der ersten Siliziumnitridschicht (21) die Anforderung an eine Lambda/4-Entspiegelung erfüllt.

7. Verfahren nach einem der vorhergehenden Ansprüche, **dadurch gekennzeichnet, dass** eine zweilagige Mehrlagenschicht mit einer ersten Schicht (21), die mit einer ersten Beschichtungsrate abgeschieden wird, und einer zweiten Schicht (22), die mit einer dazu vergleichsweise hohen zweiten Beschichtungsrate abgeschieden wird, ausgebildet wird.

8. Verfahren nach einem der vorhergehenden Ansprüche, **dadurch gekennzeichnet, dass** vor dem Abscheiden einer ersten Schicht (21, 31) der Mehrlagenschicht und/oder der Gradientenschicht eine Plasmavorbehandlung der Substratoberfläche des Substrates (9) in der gleichen Prozesskammer (1) durchgeführt wird, in der auch die Plasmabeschichtung erfolgt.

9. Verfahren nach einem der vorhergehenden Ansprüche, **dadurch gekennzeichnet, dass** unmittelbar nach dem Abscheiden der Mehrlagenschicht und/oder der Gradientenschicht eine Substratnachbehandlung in der gleichen Prozesskammer (1) durchgeführt wird, in der auch die Plasmabeschichtung erfolgt.

10. Verfahren nach Anspruch 8, **dadurch gekennzeichnet, dass** die Plasmavorbehandlung eine Plasmaoxidation umfasst.

11. Verfahren nach Anspruch 10, **dadurch gekennzeichnet, dass** die Mehrlagenschicht und/oder die Gradientenschicht auf der oxidierten Substratoberfläche in der gleichen Prozesskammer (1) abgeschieden wird und die Abscheidung eine Abscheidung wenigstens einer Aluminiumoxidschicht (32) umfasst.

12. Verfahren nach Anspruch 11, **dadurch gekennzeichnet, dass** bei der Plasmamoxidation auf dem Substrat eine Oberflächenoxidschicht (31) mit einer Schichtdicke von maximal 3 nm erzeugt wird, dass die Aluminiumoxidschicht (32) mit einer Schichtdicke von 20 nm bis 100 nm erzeugt wird und dass auf der Aluminiumoxidschicht (32) Siliziumoxid, Siliziumnitrid oder Siliziumoxynitrid (33) mit einer Schichtdicke von 30 nm bis 150 nm abgeschieden wird.

13. Verfahren nach einem der vorhergehenden Ansprüche, **dadurch gekennzeichnet, dass** die Mehrlagenschicht aus wenigstens zwei Schichten ausgebildet wird, wobei eine erste, auf dem Substrat (9) abgeschiedene Schicht eine Dotanten enthaltende Quellschicht ist und wobei eine weitere Schicht der Mehrlagenschicht eine Verkapselungsschicht ist, deren optische Eigenschaften auf die der ersten Schicht abgestimmt sind oder werden.

14. Verfahren nach Anspruch 13, **dadurch gekennzeichnet, dass** die wenigstens zwei Schichten Siliziumnitridschichten sind.

15. Verfahren nach Anspruch 13 oder 14, **dadurch gekennzeichnet, dass** die Mehrlagenschicht auf der Vorderseite und der Rückseite des Substrates (9) abgeschieden wird.

## Claims

1. Method for depositing multi-layered layers and/or gradient layers on at least one substrate (9) in an inline plasma coating system with at least one process chamber (1), in which at least two individual plasma sources (2, 4, 5, 6) are successively arranged in the transport direction (A) of the substrates (9), by means of plasma-assisted chemical gas phase deposition, wherein the at least two plasma sources (2, 4, 5, 6) are operated with different process conditions at excitation frequencies between 10 kHz and 2.45 GHz and for the at least two plasma sources (2, 4, 5, 6) linearly scalable plasma sources with their own gas supply and power supply are used, at least one of the at least two plasma sources is thereby pulsed and the substrate (9) is continuously or discontinuously transported through the different coating areas of the individual plasma sources (2, 4, 5, 6), wherein the movement of the substrates (9) is carried out linearly in the transport direction (A), in the opposite direction to the transport direction (A) or oscillating bidirectionally, and wherein at least one defined two-ply layer stack with different layer features of the individual layers (21, 22, 23; 31, 32, 33) and/or at least one defined gradient layer is deposited on the substrate (9), **characterized in that** the at least two plasma sources (2, 4, 5, 6) are operated with different electrical operation conditions and the operation of the at least two plasma sources (2, 4, 5, 6) with different electrical operation conditions comprises a usage of different plasma excitation frequencies.

2. Method according to claim 1, **characterized in that** the at least two plasma sources (2, 4, 5, 6) are operated with different pulse frequencies, peak powers and/or duty cycles of the pulses.

3. Method according to one of the preceding claims, **characterized in that** at least two of the plasma sources (2, 4, 5, 6) are interconnected to one or to several groups and that the plasma sources of one group are operated with the same process conditions.

4. Method according to one of the preceding claims, **characterized in that** at least one of the two plasma sources (2, 4) is operated at a plasma excitation frequency of 10 KHz to 300 MHz and at least one further of the two plasma sources (5, 6) is operated at a plasma excitation frequency of 100 MHz to 2.45 GHz.

5. Method according to one of the preceding claims, **characterized in that** gas mixtures are reduced by means of conductance screens arranged between the individual plasma sources (2, 4, 5, 6).

6. Method according to one of the preceding claims, **characterized in that** the multi-layered layer and/or the gradient layer is an anti-reflection coating for crystalline silicon solar cells composed of at least two silicon nitride layers (21, 22, 23) with differing layer composition and layer thickness, wherein the first silicon nitride layer (21) is deposited in such a way that it acts as a surface passivation layer on the substrate, and a second silicon nitride layer (22) is deposited on the first silicon nitride layer in such a way that it acts as a hydrogen source and, along with the fist silicon nitride layer (21), fulfils the requirement for a lambda/4 anti-reflection coating.

7. Method according to one of the preceding claims, **characterized in that** a two-ply multi-layered layer is formed with a first layer (21), which is deposited with a first depositing rate and a second layer (22), which is deposited with a second, high depositing rate compared to the first.

8. Method according to one of the preceding claims, **characterized in that** before the deposition of a first layer (21, 31) of the multi-layered layer and/or the gradient layer, a plasma pretreatment of the substrate surface of the substrate (9) is carried out in the same process chamber (1), in which the plasma coating takes place.

9. Method according to one of the preceding claims, **characterized in that** immediately after the deposition of the multi-layered layer and/or the gradient layer, a substrate post treatment is carried out in the same process chamber (1), in which the plasma coating takes place.

10. Method according to claim 8, **characterized in that** the plasma pretreatment comprises a plasma oxidation.

11. Method according to claim 10, **characterized in that** the multi-layered layer and/or the gradient layer is deposited on the oxidized substrate surface in the same process chamber (1) and the deposition comprises a deposition of at least one aluminum oxide layer (32).

12. Method according to claim 11, **characterized in that** during the plasma oxidation on the substrate, a surface oxide layer (31) with a layer thickness of a maximum of 3 nm is generated on the substrate, the aluminum oxide layer (32) is generated with a layer thickness of 20 nm to 100 nm and that silicon oxide, silicon nitride or silicon oxynitride (33) with a layer thickness of 30 nm to 150 nm is deposited on the aluminum oxide layer (32).

13. Method according to one of the preceding claims, **characterized in that** the multi-layered layer is formed from at least two layers, wherein a first layer deposited on the substrate (9) is a source layer containing dopants and wherein another layer of the multi-layered layer is an encapsulating layer, whose optical features are or get adjusted to that of the first layer.

14. Method according to claim 13, **characterized in that** the at least two layers are silicon nitride layers.

15. Method according to claim 13 or 14, **characterized in that** the multi-layered layer is deposited on the front face and the rear face of the substrate (9).

## Revendications

1. Procédé de dépôt de revêtements multicouches et/ou de couches à gradient sur au moins un substrat (9) dans un système de revêtement à plasma en ligne comportant au moins une chambre de traitement (1) dans laquelle au moins deux sources de plasma individuelles (2, 4, 5, 6) sont disposées l'une après l'autre dans le sens du transport (A) des substrats (9), par dépôt chimique en phase gazeuse assisté par plasma, les au moins deux sources de plasma (2, 4, 5, 6) fonctionnant dans différentes conditions de traitement à des fréquences d'excitation comprises entre 10 kHz et 2,45 GHz et pour les au moins deux sources de plasma (2, 4, 5, 6), des sources de plasma linéairement échelonnables dotées de leur propre alimentation en gaz et alimentation électrique étant utilisées, au moins une des au moins deux sources de plasma étant ainsi pulsée et le substrat (9) étant transporté en continu ou en discontinu à travers les différentes zones de revêtement des sources de plasma individuelles (2, 4, 5, 6), le mouvement des substrats (9) étant effectué linéairement dans le sens de transport (A), dans le sens contraire du sens de transport (A) ou de manière bidirectionnelle par oscillations, et au moins un empilement défini de deux couches dont les couches individuelles (21, 22, 23; 31, 32, 33) ont des propriétés différentes, et/ou au moins une couche à gradient définie étant déposés sur le substrat (9), **caractérisé en ce que** les au moins deux sources de plasma (2, 4, 5, 6) fonctionnent dans des conditions de fonctionnement électrique différentes et le fonctionnement des au moins deux sources de plasma (2, 4, 5, 6) présentant des conditions de fonctionnement électrique différentes comprend l'utilisation de fréquences d'excitation du plasma différentes.

2. Procédé selon la revendication 1, **caractérisé en ce que** les au moins deux sources de plasma (2, 4, 5, 6) fonctionnent à des fréquences d'impulsions, des puissances de crête et/ou des durées d'activation des impulsions différentes.

3. Procédé selon l'une des revendications précédentes, **caractérisé en ce qu'**au moins deux des sources de plasma (2, 4, 5, 6) sont interconnectées à un ou plusieurs groupes et les sources de plasma d'un groupe fonctionnent dans les mêmes conditions de traitement.

4. Procédé selon l'une des revendications précédentes, **caractérisé en ce qu'**au moins une des deux sources de plasma (2, 4) ayant une fréquence d'excitation du plasma de 10 kHz à 300 MHz et au moins une autre des deux sources de plasma (5, 6) ayant une fréquence d'excitation du plasma de 100 MHz à 2,45 GHz est utilisée.

5. Procédé selon l'une des revendications précédentes, **caractérisé en ce que** les mélanges de gaz sont réduits au moyen de diaphragmes à conductance disposés entre les différentes sources de plasma (2, 4, 5, 6).

6. Procédé selon l'une des revendications précédentes, **caractérisé en ce que** le revêtement multicouche et/ou la couche à gradient est un revêtement antireflet pour cellules solaires en silicium cristallin constitué d'au moins deux couches de nitrure de silicium (21, 22, 23) dont la composition et l'épaisseur sont différentes, une première couche de nitrure de silicium (21) étant déposée de manière à agir en tant que couche de passivation de surface sur le substrat, et une seconde couche de nitrure de silicium (22) étant déposée sur la première couche de nitrure de silicium de manière à agir en tant que source d'hydrogène et à remplir conjointement avec la première couche de nitrure de silicium (21) l'exigence d'un antireflet lambda/4.

7. Procédé selon l'une des revendications précédentes, **caractérisé en ce qu'**est formé un revêtement multicouche, bicouche, comportant une première couche (21) déposée à une première vitesse de revêtement, et une seconde couche (22) déposée à une seconde vitesse de revêtement élevée comparée à la première.

8. Procédé selon l'une des revendications précédentes, **caractérisé en ce que**, avant le dépôt d'une première couche (21, 31) du revêtement multicouche et/ou de la couche à gradient, un traitement préalable au plasma de la surface du substrat (9) est effectué dans la même chambre de traitement (1) où le revêtement au plasma a également lieu.

9. Procédé selon l'une des revendications précédentes, **caractérisé en ce que**, immédiatement après le dépôt du revêtement multicouche et/ou de la couche à gradient, un post-traitement du substrat est effectué dans la même chambre de traitement (1) où le revêtement au plasma a également lieu.

10. Procédé selon la revendication 8, **caractérisé en ce que** le prétraitement au plasma comprend une oxydation au plasma.

11. Procédé selon la revendication 10, **caractérisé en ce que** le revêtement multicouches et/ou la couche à gradient est déposée sur la surface du substrat oxydé dans la même chambre de traitement (1) et le dépôt comprend un dépôt d'au moins une couche d'oxyde d'aluminium (32).

12. Procédé selon la revendication 11, **caractérisé en ce que** lors de l'oxydation au plasma sur le substrat, une couche d'oxyde de surface (31) d'une épaisseur maximale de 3 nm est produite, **en ce que** la couche d'oxyde d'aluminium (32) ayant une épaisseur de 20 nm à 100 nm est produite, et **en ce que** de l'oxyde de silicium, du nitrure de silicium ou de l'oxynitrure de silicium (33) ayant une épaisseur de couche de 30 nm à 150 nm est déposé sur la couche d'oxyde d'aluminium (32).

13. Procédé selon l'une des revendications précédentes, **caractérisé en ce que** le revêtement multicouche est formé d'au moins deux couches, une première couche déposée sur le substrat (9) étant une couche gonflante contenant un dopant et une autre couche du revêtement multicouche étant une couche d'encapsulation, dont les propriétés optiques sont ou seront adaptées à celles de la première couche.

14. Procédé selon la revendication 13, **caractérisé en ce que** les au moins deux couches sont des couches de nitrure de silicium.

15. Procédé selon la revendication 13 ou 14, **caractérisé en ce que** le revêtement multicouche est déposé sur la face avant et la face arrière du substrat (9).
